# DEMANDE DE BREVET EUROPEEN

(11) **EP 1 489 648 A1**
(43) Date de publication de la demande: **22.12.2004**
(21) Numéro de dépôt: 04291417.6
(22) Date de dépôt: 07.06.2004
(51) Int. Cl.: H01L 21/285

(54) **Procédé de formation selective de siliciure sur une plaque de materiau semi-conducteur**

(30) Priorité: 20.06.2003 FR 0307474
(71) Demandeur: STMicroelectronics S.A., 92120 Montrouge (FR)
(72) Inventeur: Regnier, Christophe, 38660 Saint Hilaire du Touvet (FR); Wacquant, François, 38660 Saint Ismier (FR)
(74) Mandataire: Verdure, Stéphane

(57) **Abrégé**

Un procédé de formation sélective de siliciure sur une plaque de matériau semi-conducteur comprenant des zones exposées à siliciurer et des zones exposées à ne pas siliciurer, comprend les étapes de :
a) formation d'un masque mince de résine au dessus des zones à ne pas siliciurer ;
b) implantation pleine plaque d'ions à travers ce masque de manière à former sous la couche de résine un résidu d'implantation (21,22,23) à partir de la résine ;
c) retrait de la couche de résine ;
d) dépôt conforme d'une couche de métal (30) sur la plaque ;
e) traitement thermique rapide, de manière à provoquer la formation de siliciure (31,32,33) par siliciuration du métal déposé à l'étape d) ; et,
f) retrait du métal n'ayant pas réagi au traitement thermique de l'étape e).

## Description

La présente invention concerne un procédé de formation sélective de siliciure sur une plaque de matériau semi-conducteur ("wafer" en anglais) comprenant des zones exposées à siliciurer et des zones exposées à ne pas siliciurer.

Elle trouve des applications, notamment, dans la fabrication des transistors MOS (de l'anglais "Metal Oxide Semiconductor"), dans toutes les technologies utilisant les siliciures, en particulier les technologies à 0,18 µm, 0,12 µm, 90 nm, ou 65 nm.

Les transistors MOS sont des composants importants des dispositifs semi-conducteurs, et les performances électriques de la grille des transistors MOS affectent directement la qualité de ces dispositifs. La zone de grille d'un transistor MOS comprend typiquement une couche de silicium poly-cristallin (poly-silicium) ou une couche de silicium amorphe utilisée comme couche conductrice principale, et parfois une couche de siliciure, par exemple le siliciure de cobalt (Co), empilée sur la couche conductrice principale. De même, les zones actives de source et de drain d'un transistor MOS comprennent une couche de silicium dopé, qui peut être recouverte d'une couche de siliciure. Ces couches de siliciure fournissent un bon contact ohmique, et, de ce fait, elles réduisent les résistances de couche du transistor MOS et augmentent la vitesse opérationnelle du dispositif semi-conducteur l'incorporant.

Selon les besoins de l'application, il peut ainsi être nécessaire de siliciurer les zones de grille, de drain et/ou de source de certains transistors MOS, et de ne pas siliciurer les zones correspondantes des autres transistors réalisés sur la plaque. En effet, on peut par exemple avoir besoin de réduire les résistances de contact de certains transistors, et au contraire de protéger certains autres transistors contre les décharges électrostatiques par une forte résistance d'accès.

Dans l'état de la technique, on utilise classiquement un masque pour empêcher la formation de siliciure sur les zones à ne pas siliciurer. Ce masque peut être formé d'un empilement comprenant d'une part une couche d'oxyde, par exemple du dioxyde de silicium (Si02) obtenu par CVD (de l'anglais "Chemical Vapour Deposition") à partir du tétraéthylorthosilicate (TEOS), et d'autre part une couche de nitrure, par exemple du nitrure de silicium (SiN). Un tel masque est parfois appelé "SiProtect" dans le jargon de l'Homme du métier. Le siliciure ne se forme pas sur les zones protégées par ce masque.

Toutefois, la formation d'un tel masque requiert un budget thermique peu compatible avec les jonctions des technologies à 90 nm et moins. De plus elle provoque des contraintes dans les transistors MOS ("stress" en anglais). Enfin elle nécessite en soi un nombre d'étapes relativement important. En particulier, elle nécessite une étape de désoxydation avant le dépôt du Co pour enlever la couche d'arrêt en SiO2, laquelle étape occasionne un creusement non désiré des tranchées d'isolation (ou STI, de l'anglais "Shallow Trench Insulation").

L'invention a pour objet de proposer un procédé de formation sélective de siliciure sur une plaque de matériau semi-conducteur qui pallie les inconvénients de l'état de la technique précités.

Ce but est atteint gráce à un procédé de formation sélective de siliciure sur une plaque de matériau semi-conducteur comprenant des zones exposées à siliciurer et des zones exposées à ne pas siliciurer, le procédé comprenant les étapes de :
a) formation d'une couche de résine au dessus des zones à ne pas siliciurer ;
b) implantation d'ions, de préférence non dopants à travers ladite couche de résine ;
c) retrait de la couche de résine ;
d) dépôt d'une couche de métal sur la plaque, ledit métal étant apte à former un siliciure par réaction thermique avec le silicium ;
e) traitement thermique adapté pour provoquer la siliciuration du métal déposé à l'étape d) ; et,
f) retrait du métal n'ayant pas réagi au traitement thermique de l'étape e).

Lors de l'implantation de l'étape b), il se forme sous les portions de résine un composé qui résiste aux attaques chimiques couramment employées en microélectronique pour le retrait de la résine. Ce composé, ou résidu d'implantation, résulte de l'implantation de résine à l'intérieur du silicium sous-jacent, laquelle résine est entraînée avec les ions implantés. Ce phénomène est bien connu en soi mais est habituellement regardé comme un inconvénient car le résidu d'implantation ainsi formé peut être à l'origine d'une coupure de siliciure ("salicide cut" en anglais). La présente invention propose donc une utilisation astucieuse de ce phénomène permettant de résoudre le problème posé.

Avantageusement, l'étape a) de formation d'une couche de résine peut se faire à un budget thermique compatible avec les technologies de fabrication de transistors MOS à 90 nm et moins. De plus, elle ne provoque aucune contrainte dans les transistors MOS. En outre, le procédé selon la présente invention réduit le nombre d'étapes nécessaires pour la siliciuration sélective, car il peut s'intégrer dans le processus usuel de fabrication des transistors MOS.

D'autres caractéristiques et avantages de l'invention apparaîtront encore à la lecture de la description qui va suivre. Celle-ci est purement illustrative et doit être lue en regard des dessins annexés sur lesquels :

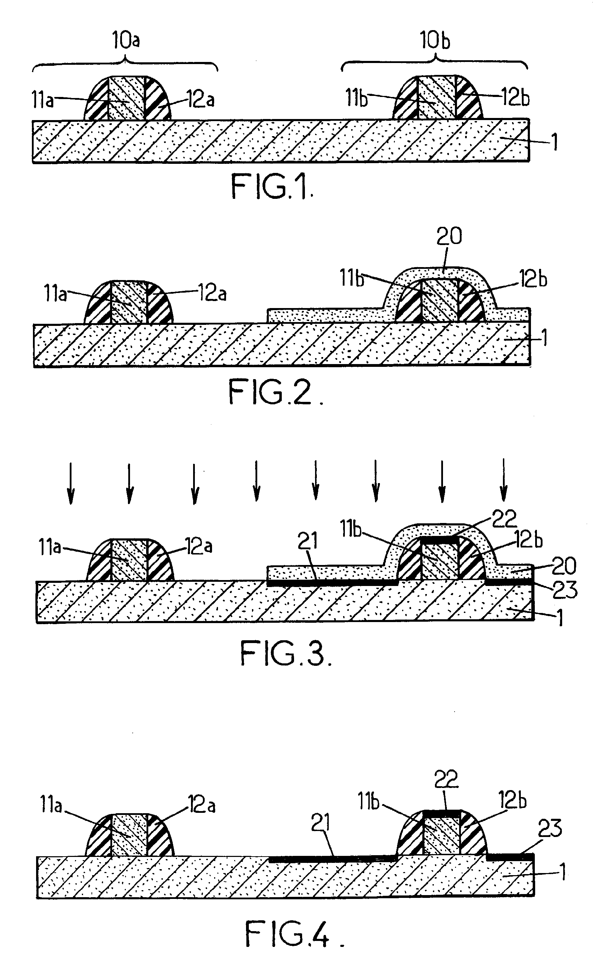

- les figures 1 à 7 sont des vues en coupe illustrant les étapes d'un exemple de mise en oeuvre du procédé selon la présente invention.

Dans les dessins, des éléments identiques portent les mêmes références. Sur chaque figure, on a représenté une portion d'une plaque comprenant un substrat de silicium 1 sur lequel ont été déposées des portions de matériau formant les grilles respectives de deux transistors adjacents.

En partie gauche de la figure 1, un transistor 10a comprend une zone de grille 11 a rapportée à la surface du substrat 1, et entourée d'une portion 12a formant l'espaceur de la grille. De même, en partie droite de la figure, un autre transistor 10b comprend une portion rapportée 11b formant la zone de grille du transistor, et qui est entourée d'une portion rapportée 12b formant l'espaceur de ce transistor. Egalement, le substrat 1 comprend des zones actives obtenues par implantation d'éléments dopants de part et d'autre de la grille de chacun des transistors 10a et 10b, correspondant aux zones de source et de drain (non représentées) de ces transistors.

On suppose ici que la grille 11 a et les zones actives du transistor 10a doivent être siliciurées en évitant la formation de siliciure sur les zones correspondantes du transistor 10b. On va maintenant décrire un mode de réalisation du procédé de siliciuration sélective selon l'invention, qui permet d'obtenir ce résultat.

Dans une première étape, illustrée par le schéma de la figure 2, on forme une couche de résine 20, par exemple une résine organique, au dessus du transistor 10b. Cette couche 20 forme un masque mince qui est par exemple obtenu par un procédé de photolithographie conventionnel. Il n'apparaît pas nécessaire de détailler ici les différentes étapes conduisant à la formation de cette couche 20. On notera simplement que, à l'issue de cette première étape, la résine recouvre les zones de la plaque à ne pas siliciurer. L'épaisseur de la couche 20 peut être comprise entre 50 nm et 400 nm.

Dans une deuxième étape illustrée par le schéma de la figure 3, on procède à l'implantation pleine plaque d'ions dans le substrat 1, à travers la couche de résine 20, par exemple en bombardant la plaque avec un faisceau d'ions correspondant. Le choix des conditions d'implantation est directement lié à la nature et l'épaisseur de la couche de résine, et à la nature des ions implantés.

Il s'agit de préférence d'ions non dopants, ce qui permet à cette étape d'implantation de ne pas modifier le dopage des zones actives des transistors, et donc de laisser intactes les propriétés électriques des transistors. Des ions non dopants sont par exemple des ions d'une substance ayant la même valence que le substrat 1, par exemple des ions germanium (Ge). Dans une variante, il s'agit d'ions d'un gaz rare tel que le xénon (Xe) ou l'argon (Ar).

Toutefois, des ions dopants à faible dose peuvent aussi être utilisés sans perturber l'architecture sous-jacente de manière irréversible.

Cette étape d'implantation est ainsi à l'origine de la formation d'un composé sous la couche de résine 20, à la partie supérieure des portions de silicium situées sous cette couche. Il se forme ainsi des portions 21 et 23 à la partie supérieure des zones de source et de drain du transistor 10b, et une portion 22 de ce composé à la partie supérieure de la zone de grille 11b du transistor 10b. Ce composé résulte de l'implantation d'une partie du matériau formant la couche de résine 20 à l'intérieur du silicium sous-jacent.

Dans une étape suivante, on procède au retrait de la partie restante de la couche de résine 20 en sorte d'obtenir la structure illustrée par le schéma de la figure 4. Après cette étape, les zones à ne pas siliciurer sont de nouveau exposées.

Ce retrait peut être effectué par tout procédé connu, notamment par attaque chimique. Ainsi qu'il est illustré, ce retrait laisse intact les portions de composé 21, 22 et 23, car ce composé est résistant aux attaques chimiques couramment utilisés en microélectronique, notamment les attaques par plasma oxydant ou HF.

On procède ensuite à la réalisation des étapes habituelles d'un procédé de siliciuration.

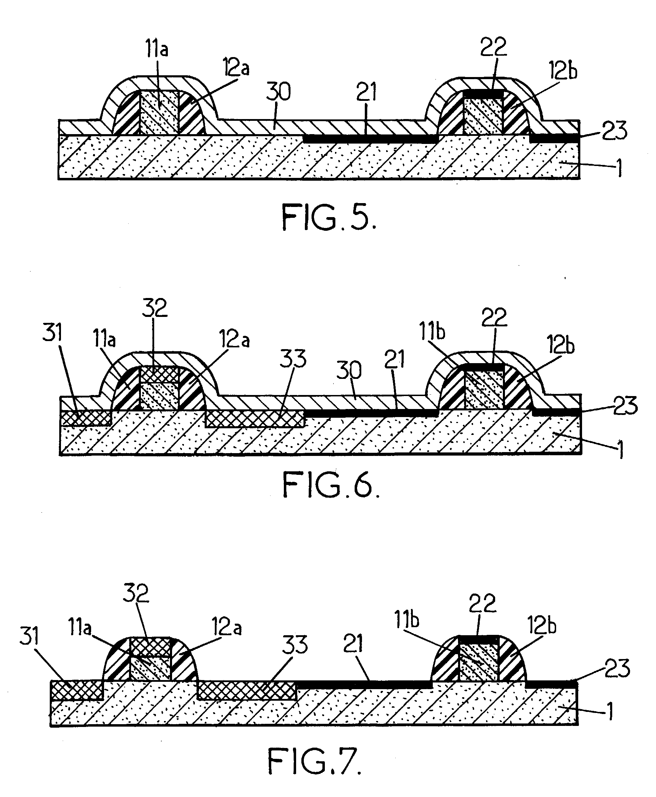

Tout d'abord, on réalise le dépôt sur la structure d'une couche de métal 30, lequel métal est adapté pour former un siliciure par recuit thermique. Ainsi qu'il est illustré à la figure 5, la couche 30 est une couche conforme qui recouvre toutes les parties exposées de la structure, en particulier les zones de grille, de source et de drain des deux transistors 10a et 10b. Dit autrement, la couche de métal recouvre aussi bien les zones à siliciurer que les zones à ne pas siliciurer.

Ce dépôt peut avoir lieu par tout procédé classique, notamment par procédé de pulvérisation ("sputtering" en anglais).

Les métaux ayant la propriété de réagir avec le silicum pour former un siliciure, formant de bons candidats, car ayant des procédés de dépôt bien maîtrisés, sont notamment le Co, le nickel (Ni), le platine (Pt), et le titane (Ti). Leurs siliciures correspondants sont respectivement le CoSi2, le NiSi, le PtSi, et le TiSi2.

A l'étape suivante, illustrée par le schéma de la figure 6, on effectue un traitement thermique, par exemple un traitement thermique rapide (ou RTP, de l'anglais "Rapid Thermal Processing"), à savoir un chauffage. Ce chauffage est à l'origine de la formation de couche de siliciure 31 et 33 à la surface des zones de source et de drain du transistor 10a, et d'une couche similaire 32 à la surface de la zone de grille 11a de ce transistor. Par contre, la présence des couches de résidus d'implantation 21, 22 et 23 sur les zones correspondantes du transistor 10b, empêche la formation de siliciure à la surface de ces zones. Dit autrement, les couches 21, 22 et 23 de résidu d'implantation forment une barrière à la formation du siliciure à l'interface entre la couche de métal 30 et les portions de silicium sous jacentes.

Dans une dernière étape, on retire le reste de la couche de métal 30 pour obtenir la configuration représentée à la figure 7. Ce retrait peut être effectué par tout procédé classique, notamment par attaque chimique.

En résumé, l'implantation d'ions Ge à travers la couche de résine 20 forme un écran qui empêche ensuite la siliciuration des zones qui étaient situées sous la résine au moment de ladite implantation. On obtient ainsi la siliciuration sélective recherchée.

On notera que la mise en oeuvre de l'invention est facilement détectable dans les dispositifs semi-conducteurs. On peut en effet constater l'absence des couches de TEOS et de nitrure, ces couches demeurant dans les zones non siliciurées lorsqu'il est mis en oeuvre un procédé selon l'art antérieur décrit en introduction. En variante ou en complément, on peut aussi constater la présence de résidus d'implantation dans les zones non siliciurées. A cet effet, on peut procéder par analyse de composition par spectroscopie de masse des ions secondaires (analyse SIMS, de l'anglais "Secondary Ion Mass Spectroscopy"), ou par une technique de détection des impuretés dans le silicium de type Auger ou similaire. Cette analyse et cette technique sont bien connues de l'Homme du métier.

L'invention a été décrite ci-dessus dans un mode de mise en oeuvre donné à titre d'exemple seulement, étant bien entendu que d'autres modes de mise en oeuvre peuvent être choisis sans sortir du cadre de la présente invention.

L'invention concerne aussi un dispositif semi-conducteur obtenu en mettant en oeuvre un procédé tel que décrit ci-dessus.

## Revendications

1. Procédé de formation sélective de siliciure sur une plaque de matériau semiconducteur (1) comprenant des zones exposées à siliciurer (10a) et des zones exposées à ne pas siliciurer (10b), le procédé comprenant les étapes de :
a) formation d'une couche de résine (20) au dessus des zones à ne pas siliciurer ;
b) implantation d'ions à travers ladite couche de résine ;
c) retrait de la couche de résine ;
d) dépôt d'une couche de métal (30) sur la plaque, ledit métal étant apte à former un siliciure par réaction thermique avec le silicium ;
e) traitement thermique adapté pour provoquer la siliciuration du métal déposé à l'étape d) ; et,
f) retrait du métal n'ayant pas réagi au traitement thermique de l'étape e).

2. Procédé selon la revendication 1, suivant lequel l'implantation de l'étape b) est une implantation pleine plaque.

3. Procédé selon la revendication 1 ou la revendication 2, suivant lequel les ions implantés à l'étape b) sont des ions non dopants.

4. Procédé selon l'une quelconque des revendications précédentes, suivant lequel les ions implantés à l'étape b) sont sélectionnés dans le groupe comprenant des ions de Ge, Xe et Ar.

5. Procédé selon l'une quelconque des revendications précédentes, suivant lequel le métal déposé à l'étape d) est sélectionné dans le groupe comprenant Co, Ni, Pt, et Ti.

6. Procédé selon l'une quelconque des revendications précédentes, suivant lequel la résine est une résine organique.

7. Application d'un procédé selon l'une quelconque des revendications 1 à 6 à la fabrication d'un dispositif semi-conducteur.

8. Dispositif semi-conducteur obtenu en mettant en oeuvre un procédé selon l'une quelconque des revendications 1 à 6.
